# EUROPEAN PATENT APPLICATION

(11) **EP 3 364 733 A1**
(43) Date of publication of application: **22.08.2018**
(21) Application number: 17460006.4
(22) Date of filing: 20.02.2017
(51) Int. Cl.: H05K 3/34

(54) **A METHOD FOR OBTAINING THERMAL EQUILIBRIUM IN THE PRODUCTION OF PRINTED CIRCUIT BOARDS ASSEMBLIES**

(71) Applicant: SEMICON sp. z o. o., 04-761 Warszawa (PL)
(72) Inventor: Tomaszewski, Jacek Maria, 05-077 Warszawa (PL); Ciszewski, Piotr, 01-460 Warszawa (PL); Sitek, Janusz, 02-107 Warszawa (PL); Steplewski, Wojciech, 05-230 Kobylka (PL)

(57) **Abstract**

A method for obtaining thermal equilibrium in the production of printed circuit boards assemblies in reflow soldering process consists in that the front surface of the brazed plate of printed circuit board assembly (1) is divided arbitrarily into zones (2a, 2b, 2c), with situated thereon large subassemblies (4) electronic of high thermal capacity and zones (3a, 3b, 3c) with other electronic components placed on them.

The entire front surface of the printed circuit board assembly (1) is covered for the duration of the soldering process with a sheet metal screen (5) divided into analogous zones (2a, 2b, 2c, 3a, 3b, 3c) of the front face of the solder printed circuit board assembly (1) contractual sectors (6a, 6b, 6c, 7a, 7b, 7c). In these contractual sectors (6a, 6b, 6c) that are located opposite the large heat-sensitive electronic subassemblies (4) in the zones (2a, 2b, 2c) of the front face of the printed circuit board assembly (1) the sheet metal screen has holes (8) for these large electronic subassemblies (4) with high thermal capacity.

## Description

The instant invention pertains to method for improving thermal equilibrium in the production of printed circuit boards assemblies by using reflow oven for reflow soldering. This is related to the need to make changes in the reflow soldering process as a result of the elimination of lead from solder used in the production of printed circuit boards' assemblies - harmful to the environment.

New lead-free solder is the most common alloy of tin and other elements (e.g. SnAgCu). However it creates thermal problems during soldering, as it has a higher melting point compared to the earlier used eutectic tin-lead alloy (SnPb).

The difference between the melting temperature of the eutectic SnPb solder and the average temperature of thermal resistance of components on the printed circuit board assembly is about 50°C and therefore does not cause any risk to these components. The SnAgCu solder has higher melting point, whereby at the same average temperature thermal resistance of printed circuit board assembly components temperature difference is decreased to about 15°C.

In the reflow oven there are several heating zones through which the individual printed circuit boards assemblies are moved by the transmission belt and heated in the subsequent zones.

In the input and output zones there is relatively low temperature - not exceeding the melting point of solder. In this way, by preheating the printed circuit boards' assemblies, a preset temperature is obtained for all soldered components. After this preheating, the printed circuit board assembly goes to the working zone, where temperature exceeding the melting point of the solder in which the main soldering process takes place.

Types of components mounted on the printed circuit board assemblies are also very diverse, but the heating intensity during their reflow soldering must be the same to achieve the same high temperature of the entire substrate, allowing for the proper soldering for such various components.

Here are some examples of components:
- passive components - for surface mount technology in diverse packages,
- semiconductors - for surface mount technology in diverse packages,
- for through hole technology - such as connectors, capacitors, resistors, diodes,
- having a spherical elements.

The fact is that so many different components have different shapes and sizes and thus have different heat capacities.

If the component has a high heat capacity, then in the working area, the intensity of heating must be high enough that the temperature of the part of the substrate in the vicinity reaches the melting point of the solder.

But at the same time, part of the substrate with small electronic components, namely a low thermal capacity, the heating intensity may be too high - cause a increase the temperature of the substrate in the vicinity of the components above upper limit temperature. In addition such overrun of the upper permissible reflow soldering temperature may also be effected for a part of the substrate on which there are both small and large electronic components.
In addition, for electronic components that are complex composite packaging structures - is often recommended reflow soldering temperature lower than normal.

Thus, if the printed circuit board assembly is configured from variety of electronic components with different recommended reflow soldering temperature, for example up to 235°C, then it is difficult to set the heating intensity to obtain the recommended temperature of no more than 220° C for other components.

Big difference between the temperature of the part of the substrate located near high-capacity components and the temperature of the substrate located near the component of low thermal capacity may cause adverse effects on the solder process.

For the correct soldering in any case, it is always necessary for the substrate to achieve temperature above the melting point of the solder SnAgCu.

It may occur that when intensity of the heating will be sufficient for a part of the substrate adjacent to components with high thermal capacity - than may be damaged the components with low thermal capacity on the other part of the substrate by too high for them temperature.

In the second extreme case, when the intensity of heating will be sufficient for a part of substrate located near the low thermal capacity components, then temperature of substrate located near the high thermal capacity components will be too low for their properly soldering.
To sum up - with this solution occur following problems:
1) The temperature in the reflow oven working space cannot be set below the required temperature for reflow soldering process.
2) The heating intensity in the reflow oven is regular enables setting the ambient temperature of the substrate to be evenly with the temperature of the substrate.
3) Especially, high intensity of the heating is in reflow zone of reflow oven working space.
4) Some components, in order to avoid their damage, cannot be maintained at the lower temperature required for them, as compared to temperature required for reflow soldering.
5) Depending on the type and especially on the size of the electronic components, there are big differences in thermal capacity.

Method of protection against overheating of the soldering process for a single electronic subassembly has been described in Japanese Patent Application No. JP2001257459 (A)

Component has an electrode soldered to a printed circuit board on which a solder paste is printed.
In this component is located element which is covered by a sealing member to prevent the increase of temperature.

This temperature - preventing element is a solid matter at normal temperature whose melting point is not less than the melting point of the solder in soldering paste, but also not higher than the temperature guaranteeing no thermal damage of the soldering electronic component.

During soldering, the thermal capacity of the anti-temperature increase element is initially added in a small extant to the thermal capacity of the electronic subassembly. However, when the temperature of this element reached a melting point, then it starts to melt. Further temperature increase of the electronic component is suppressed by melting heat of the component.

Suppression of the temperature increase of the soldered electronic component takes place independently of its shape and size and also independently of printed circuit board shape and size and as well as a method of soldering. This solution has disadvantage that pertain to a single electronic component. Besides, the anti - temperature element must be structurally adapted to each type of electronic component.

The method of protection against overheating of the soldering process for a single electronic subassembly has also been described in the Japanese Patent Application No. JP2002208772 (A).This method consists of using a device for adjusting the temperature of the reflow soldering in a such way that the device enables the setting a low reflow temperature for a particular electronic component, while for other electronic components are recommended different reflow soldering temperatures.

Regulating device has a cover shape that it covers electronic components up, which requires low temperature of reflow soldering.

In both known solutions, the thermal equilibrium during reflow soldering process of printed circuits boards assemblies is ensured by a individual overheat protection of electronic devices with low resistance to high temperature. This requires the use of components with a modified design or - additional element of protection against high temperature, or cover that covers those individual components.

According to the invention, a method of achieving a thermal balance in the production of printed circuit board assemblies in a reflow process is that the front surface of the solder printed circuit board assembly is divided into zones with large electronic components with high thermal capacity and onto zones containing other electronic components. The entire front surface of the printed circuit board assembly is covered for the duration of the soldering process with a metal sheet screen divided into zones analogous to the front surface of the printed circuit board assembly contractual sectors. In these contractual sectors, that are located opposite large electronic components of high thermal capacity, located in the frontal area of the printed circuit board assembly the sheet metal screen has holes for these large electronic components with high thermal capacity.

It is preferred if the screen is a metal sheet perforated in the contract sector, located opposite from the other electronic components found in zones of the front surface of the printed circuit board assembly on which the reverse side of the large zones are located electronic components, with a high heat capacity.

Perforation holes in each of the contractual metal plate screen may have any shape and size selected according to the size and thermal capacity of the electronic components on both surfaces of the respective circuit board assembly area.

The invention has been shown in detail in the embodiments in the drawing, in which:
- fig. 1 shows a general view of the front surface of an exemplary printed circuit board assembly with a contractual division of this surface into six zones,
- fig. 2 shows a general view of an exemplary metal sheet screen with its contractual division into six sectors, none of which three without holes for large electronic components are perforated,
- fig. 2a shows the mutual location of the frontal area of the exemplary printed circuit board assembly and metal plate screen sectors with large electronic component openings and other sectors of this screen, none of which is perforated.
- fig. 2b shows a view of a set of exemplary printed circuit board assembly and metal plate screens with large electronic sector openings and the remaining sectors of the metal sheet, none of which is perforated,
- fig. 3 shows a general view of an exemplary sheet metal screen with its contractual division into six sectors, all of which sectors without holes for large electronic components are perforated,
- fig. 3a shows the mutual location of the frontal area of the exemplary printed circuit board assembly and metal plate screen sectors with large electronic component openings and other sectors of the screen, all of which are perforated,
- fig. 3b shows a view of a set of exemplary printed circuit board assembly and a metal sheet screen with sectors with large electronics openings and the remaining sectors of the sheet metal, all of which are perforated,
- fig. 4, 5, 6, 7, 8 and 9 show a general view of an exemplary sheet metal screen with its contractual division into six sectors, some of which without openings to large electronic components are perforated,
- fig. 4a, 5a, 6a, 7a, 8a and 9a illustrate the mutual positioning of the frontal area of the exemplary printed circuit board assembly and the metal plate screen sectors with large electronic component openings and other sectors of this screen, some of which are perforated,
- fig. 4b, fig. 5b, fig. 6b, fig. 7b, fig. 8b and fig. 9b show a view of an assembly of an exemplary printed circuit board assembly and a metal plate screen with sectors with large electronics openings and the remaining sectors of said metal plate, some of them are perforated.

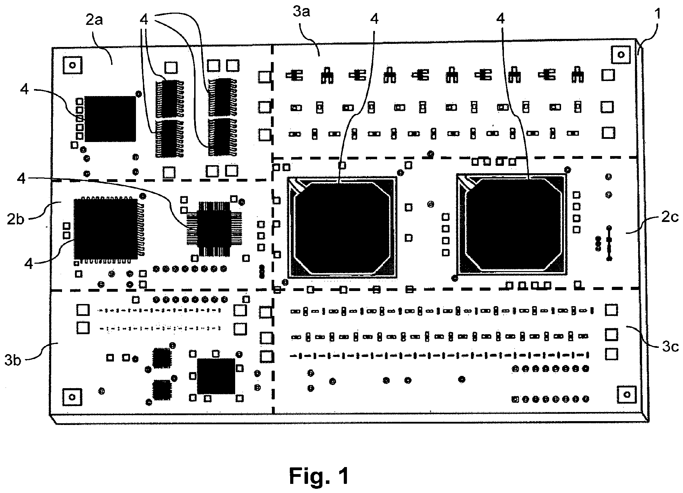

Printed circuit board assembly 1 is subject to invention according to reflow soldering method which front face is shown in fig. 1. The front surface of the printed circuit board assembly 1 has been subdivided into three zones 2a, 2b and 2c, on which are placed large electronic subassemblies 4 with large thermal capacity and three zones 3a, 3b and 3c on which they are placed to be soldered small electronic components with low thermal capacity. The boundaries of each zone 2a, 2b, 2c, 3a, 3b and 3c of the surface of printed circuit board assembly 1 are shown schematically in fig. 1 as bar lines.

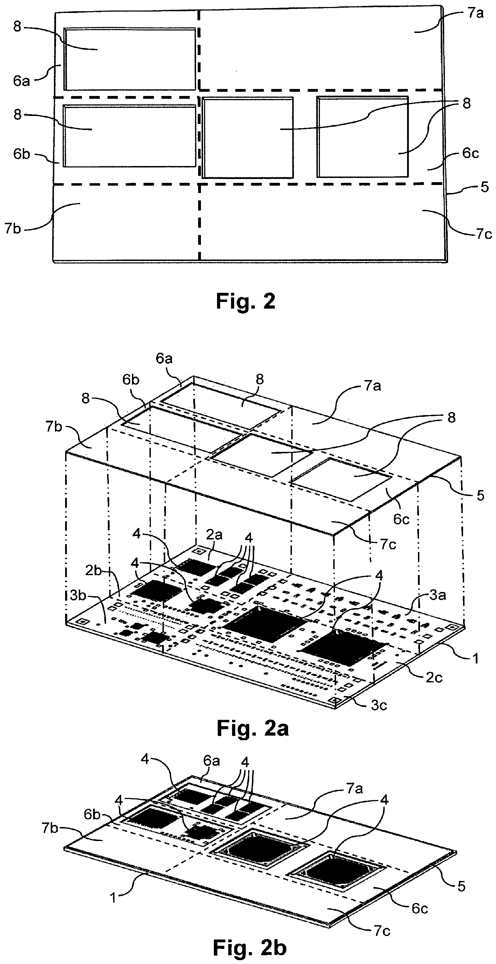

At the time of reflow soldering a printed circuit board assembly 1 is covered with made of the metal screen 5a shown in fig. 2, which surface is arbitrarily divided into three sectors 6a, 6b and 6c in which are formed holes 8 intended for the containment of large electronic subassemblies 4 with high thermal capacity from printed circuit board 1, and three other sectors 7a, 7b and 7c, all or some of which may be perforated. The boundaries of individual sectors 6a, 6b, 6c, 7a, 7b and 7c made of metal screen 5 are schematically shown as bar lines.

As shown in fig. 2a, each of the zones 2a, 2b, 2c, 3a, 3b and 3c of a printed circuit board assembly 1 is covered with one of the sectors 6a, 6b, 6c, 7a, 7b and 7c made of metal screen 5 respectively. This was illustrated schematically by means of bar lines.

In fig. 2b, a set consisting of a printed circuit board assembly 1 and placed on it a metal screen 5 has been shown to be introduced into the reflow oven. Through openings in the sectors 6a, 6b and 6c visible are large electronic subassemblies 4 of the high thermal capacity of printed circuit board assembly 1. In contrast, the other three sectors 7a, 7b and 7c made of the metal screen 5 - in this embodiment of the invention are not perforated.

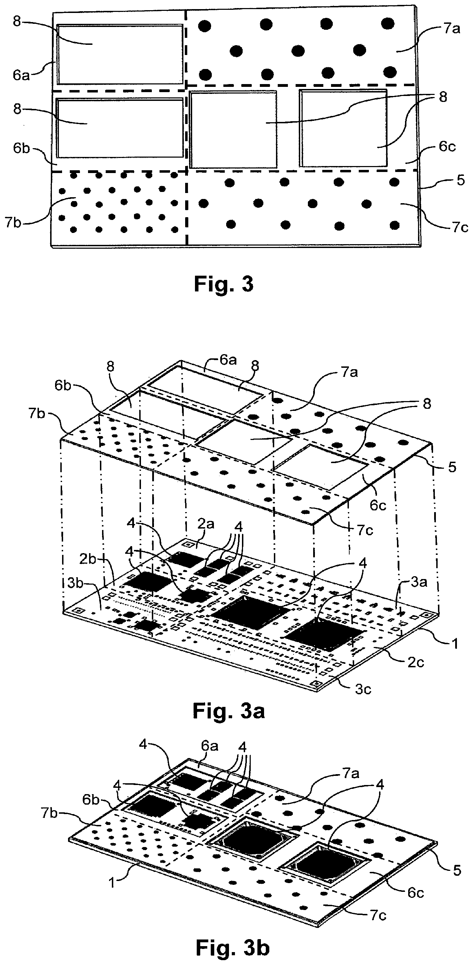

In another example of the invention shown in fig. 3 of the drawings, they are perforated all sectors 7a, 7b and 7c made of the metal screen 5. Perforation holes in all these sectors 7a, 7b and 7c are round. Their quantity and size are determined by the type and thermal capacity of the electronic components located in the respective zones 3a, 3b and 3c, respectively, on both the front face and the surface of the printed circuit board assembly 1.

The mutual location of the printed circuit board assembly 1 and of the metal screen 5 is shown for this embodiment in fig. 3a. On the other hand, a set consisting of this printed circuit board assembly 1 and placed on it metal screen 5 with perforated all three sectors, intended for introduction into the reflow oven, is shown in fig. 3b.

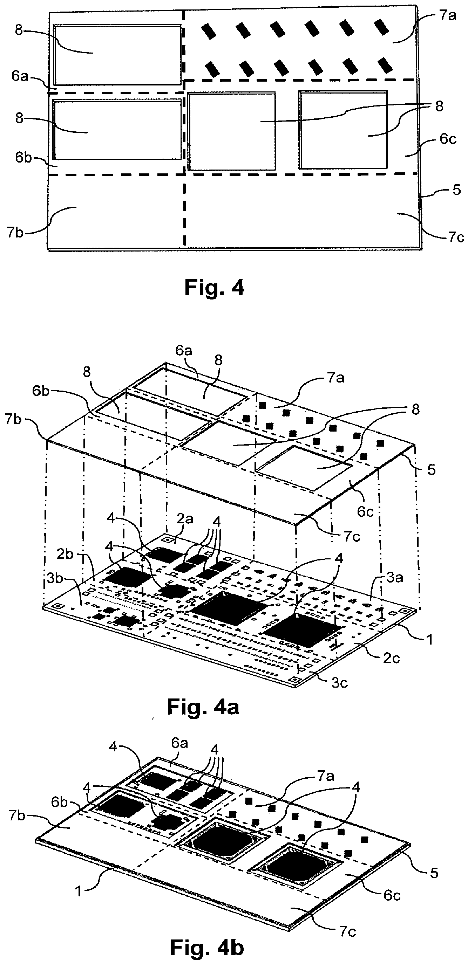

In the examples of the invention shown in fig. 4, fig. 5 and fig. 6 of the drawings, one of the three sectors 7a, 7b and 7c of the metal screen 5 is perforated.

In the example shown in fig. 4, the perforation holes in the only perforated sector 7a are rectangular. The mutual location of the printed circuit board assembly 1 and made of the metal screen 5 is shown for this embodiment in fig. 4a. On the other hand, a set consisting of this printed circuit board assembly 1 and located on it a metal screen 5 with a perforated sector 7a, intended for introduction into a reflow oven, is shown in fig. 4b.

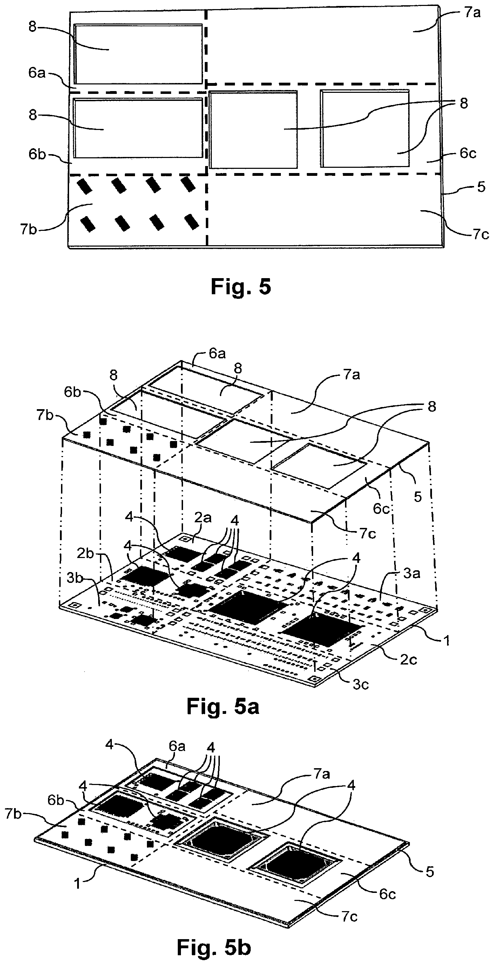

In another embodiment shown in fig. 5, the perforation holes in another unique perforated sector 7b are also rectangular. The mutual location of the printed circuit board assembly 1 and of the metal screen 5 is shown for this embodiment in fig. 5a. On the other hand, a set consisting of this printed circuit board assembly 1 and placed on it made of a metal screen 5 with a perforated sector 7b, intended for introduction into a reflow oven, is shown in fig. 5b.

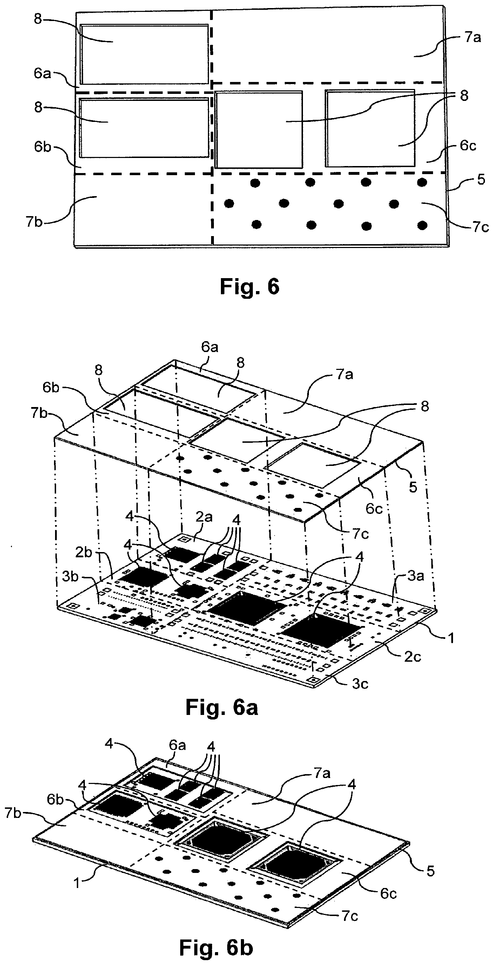

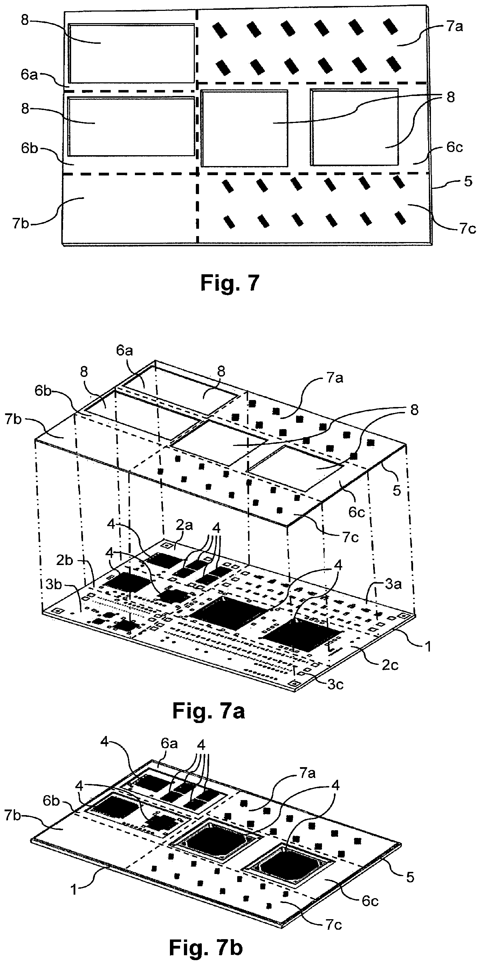

In another example shown in fig. 6, the perforation holes in the other single perforated sector 7c are round. The mutual location of the printed circuit board assembly 1 and of the metal screen 5 is shown for this embodiment in fig. 6a. On the other hand, a set consisting of this printed circuit board assembly 1 and located on it made of a metal screen 5 with a perforated sector 7c, intended for introduction into a reflow oven, is shown in fig. 7b.

In examples of the invention shown in fig. 7, fig. 8 and fig 9, there are two perforated with three sectors 7a, 7b and 7c made of the metal screen 5.

A further example shown in fig. 7, the perforated holes in the two perforated sectors 7a and 7c are rectangular. The mutual location of the printed circuit board assembly 1 and of the metal screen 5 is shown for this embodiment in fig. 7a. On the other hand, a set consisting of this printed circuit board assembly 1 and placed on it made of metal screen 5 with perforated sectors 7a and 7c intended for introduction into the reflow oven is shown in Fig. 7b.

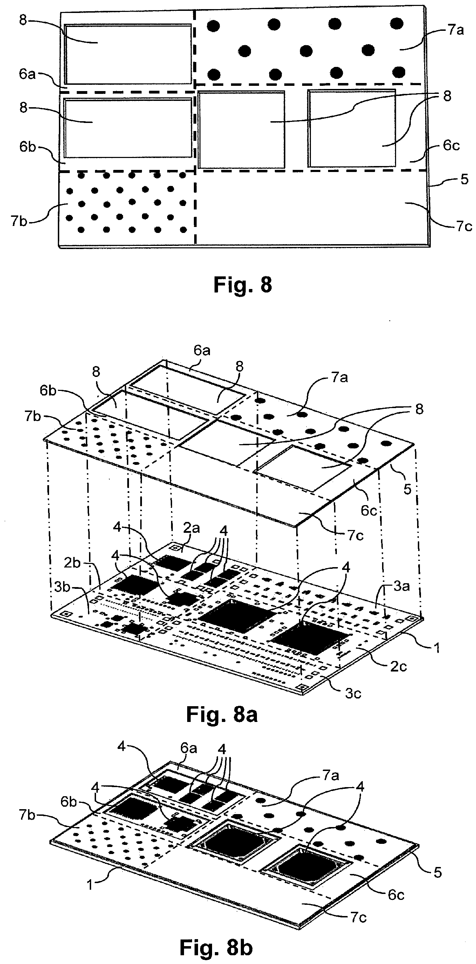

Another example shown in fig. 8, the perforation holes in both perforated sectors 7a and 7b are circular. The mutual location of the printed circuit board assembly 1 and of the metal screen 5 is shown for this embodiment in fig. 8a. On the other hand, a set consisting of this printed circuit board assembly 1 and located on it made of metal screen 5 with perforated sectors 7a and 7b intended for introduction into a reflow oven, is shown in fig. 8b.

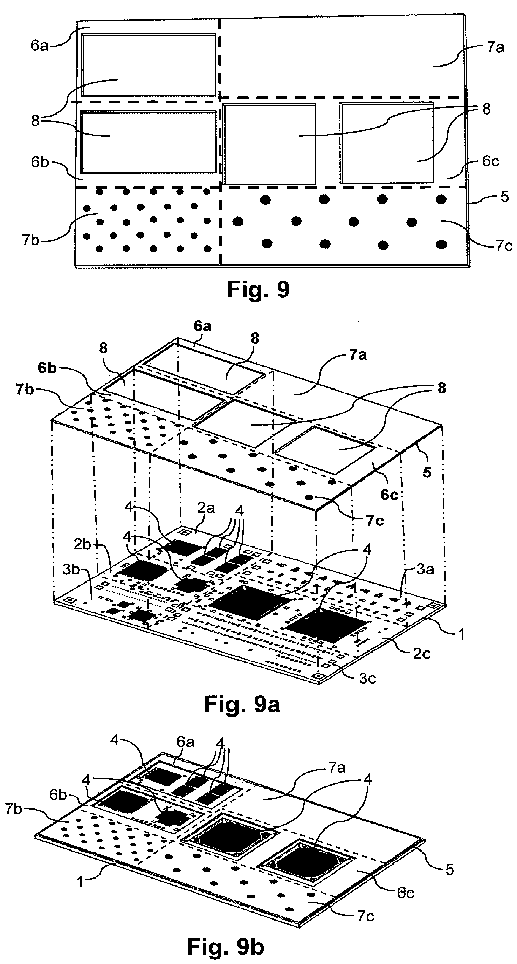

In another example shown in fig. 9, the perforation holes in both perforated sectors 7b and 7c are round. The mutual location of the printed circuit board assembly 1 and of the metal screen 5 is shown for this embodiment in fig. 9a. On the other hand, a set consisting of this printed circuit board assembly 1 and placed on it made of metal screen 5 with perforated sectors 7b and 7c, intended for introduction into a reflow oven, is shown in fig. 9b.

## Claims

1. A method of achieving a thermal equilibrium in the production of printed circuit boards assemblies in a reflow soldering process, **characterized in that** the front surface of the printed circuit board assembly (1) is subdivided into zones (2a, 2b, 2c) with large electronic subassemblies (4) with high thermal capacity and into zones (3a, 3b, 3c) with other electronic components placed on them, whereby the entire front surface of the printed circuit board assembly (1) is covered for the duration of the soldering process with a metal screen (5) divided analogous into zones (2a, 2b, 2c, 3a, 3b, 3c) of the front surface of the solder printed circuit board assembly (1) contractual sectors (6a, 6b, 6c, 7a, 7b, 7c), and in these contractual sectors (6a, 6b, 6c) that are located opposite of large electronic subassemblies (4) of high thermal capacity in the zones (2a, 2b, 2c) of the front surface of the circuit board assembly (1) and the metal screen (5) has holes (8) for these large electronic subassemblies (4) with high thermal capacity.

2. Method according to claim 1, **characterized in that** the metal screen (5) is perforated in stipulated sectors (7a, 7b, or 7c) from opposite electronic components located in the zones (3a, 3b, 3c) of the front surface of the printed circuits board assembly (1) in which high-volume electronic components of high thermal capacity are located on the reverse side of a given zones (2a, 2b, or 2c).

3. Method according to claim 2, **characterized in that** the perforation holes in each of the contracted zones (2a, 2b, or 2c) of the metal screen (5) are of any shape and size.
